# EUROPÄISCHE PATENTSCHRIFT

(11) **EP 0 542 094 B1**
(45) Veröffentlichungstag und Bekanntmachung des Hinweises auf die Patenterteilung: **22.01.1997**
(21) Anmeldenummer: 92118777.9
(22) Anmeldetag: 02.11.1992
(51) Int. Cl.: G01R 31/305

(54) **Korpuskularstrahltestverfahren mit Gegenspannungsnachführung**
Corpuscular beam test method using voltage control
Procédé de test à rayons corpusculaire avec régulation de tension

(30) Priorität: 05.11.1991 DE 4136407
(43) Veröffentlichungstag der Anmeldung: 19.05.1993
(73) Patentinhaber: EBETECH Electron-Beam Technology Vertriebs GmbH, 85551 Heimstetten (DE)
(72) Erfinder: Schmitt, Reinhold, Dipl.-Ing., W-8000 München 83 (DE)
(74) Vertreter: Tetzner, Volkmar, Dr.-Ing. Dr. jur.

(56) Entgegenhaltungen:
- EP-A- 0 309 956
- DE-A- 3 941 178
- GB-A- 2 126 355
- US-A- 4 629 889

## Beschreibung

Die vorliegende Erfindung betrifft ein Korpuskularstrahltestverfahren nach dem Oberbegriff des Patentanspruchs 1.

Ein Verfahren dieser Art ist aus den Proceedings of SPIE - The International Society of Optical Engineering, 11. bis 12.03. 1986, Santa Clara, USA, Vol. 632, Seite 232 bis 236, bekannt. Dabei handelt es sich um ein Elektronenstrahltestverfahren zur quantitativen Spannungsmessung mit einer "Software-Regelschleife". Die Regelschleife bewirkt beispielsweise, daß eine Gegenspannung so nachgeführt wird, daß ein Detektorstrom gleich einem vorgegebenen Referenzstrom wird und daß zwischen einer zu messenden Probenspannung und der sich einstellenden Gegenspannung ein linearer Zusammenhang besteht.

Ein weiteres Verfahren dieser Art ist aus der EP-A-0 309 956 bekannt.

Der Erfindung liegt die Aufgabe zugrunde, ein Verfahren der eingangs genannten Art anzugeben, das sich vor allem für schnelle quantitative Tests eignet, eine maximale Meßempfindlichkeit besitzt und relativ einfach durchführbar ist.

Die Aufgabe wird erfindungsgemäß durch die im kennzeichnenden Teil des Patentanspruchs 1 angegebenen Merkmale gelöst.

Der mit der Erfindung erzielbare Vorteil liegt insbesondere darin, daß für die Testanordnung keinerlei bandbreitenbegrenzende Elemente, wie zum Beispiel Regelverstärker etc., benötigt werden und daß damit eine relativ hohe Verarbeitungsgeschwindigkeit erreicht wird.

Die Ansprüche 2 bis 6 sind auf Weiterbildungen des erfindungsgemäßen Verfahrens gerichtet.

Die Erfindung wird nachfolgend anhand der Zeichnungen näher erläutert. Dabei zeigt
- Figur 1: ein Schaltbild einer Anordnung zur Durchführung eines bekannten Korpuskularstrahltestverfahrens,
- Figur 2: ein Diagramm mit Spektrometerkennlinien zur Figur 1,
- Figur 3: ein Schaltbild einer Anordnung zur Durchführung eines erfindungsgemäßen Korpuskularstrahltestverfahrens,
- Figur 4: ein Diagramm mit Spektrometerkennlinien zur Figur 3 und
- Figur 5: ein Ausführungsbeispiel einer Ansteuereinheit zu Figur 3.

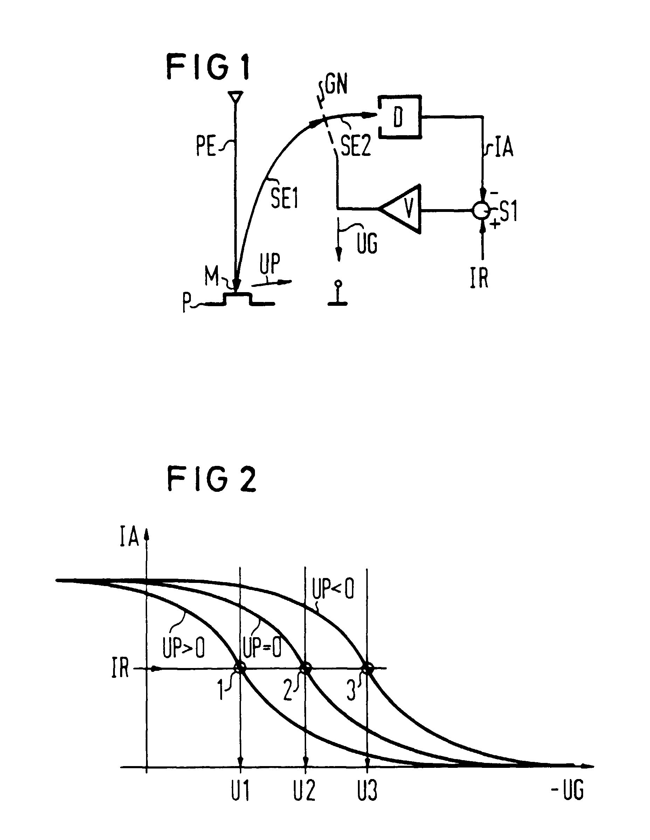

In Figur 1 ist eine Anordnung zur Durchführung eines bekannten Korpuskularstrahltestverfahrens mit Gegenspannungsnachführung gezeigt, wobei ein Primärelektronenstrahl PE auf eine Meßstelle M einer Probe P gerichtet ist. Von der Meßstelle M bewegen sich Sekundärelektronen SE1 auf ein Gegenfeldnetz GN zu und ein Teil SE2 der Sekundärelektronen erreicht einen Detektor D. An einer Summationsstelle S1 wird ein im Detektor erzeugter Detektorstrom IA mit einem Referenzstrom IR verglichen und über einen Verstärker V in Form einer Gegenspannung UG dem Gegenfeldnetz GN zugeführt. Es handelt sich hierbei also um einen Regelkreis, der die Gegenspannung UG am Gegenfeldnetz GN so nachführt, daß der Detektorstrom IA stets für alle Probenspannungen UP dem vorgegebenen Referenzstrom IR entspricht. In Figur 2 ist ein Diagramm mit Spektrometerkennlinien zu Figur 1 dargestellt, bei dem über eine negative Gegenspannung -UG der Detektorstrom IA aufgetragen ist und jeweils eine Spektrometerkennlinie für die Probenspannung UP größer 0, UP gleich 0 und UP kleiner 0 dargestellt sind. Da der Detektorstrom IA in Form des Referenzstromes IR fest vorgegeben ist und die Spektrometerkennlinien jeweils nur um den jeweiligen Probenspannungshub in Richtung der UG-Achse verschoben sind, besteht ein linearer Zusammenhang zwischen dem jeweiligen Gegenspannungshub und dem jeweiligen Probenspannungshub. Der Referenzstrom IR und die Spektrometerkennlinien für die Probenspannung UP größer 0 bilden dabei einen Arbeitspunkt 1 der zu einer Gegenspannung -UG = U1 führt. In entsprechender Weise bildet die Spektrometerkennlinie für die Probenspannung UP = 0 den Arbeitspunkt 2 und führt zur Gegenspannung -UG = U2 und die Spektrometerkennlinie für die Probenspannung UP kleiner 0 zu einem Arbeitspunkt 3 und einer Gegenspannung -UG = U3. Die Gegenspannung wird dabei umso negativer je negativer die Probenspannung UP wird. Das bekannte Korpuskularstrahltestverfahren kann aufgrund des linearen Zusammenhangs zwischen einem Probenspannungshub und einem Gegenspannungshub besonders gut für quantitative Tests eingesetzt werden, besitzt jedoch aufgrund des erforderlichen Regelkreises eine relativ niedrige Verarbeitungsgeschwindigkeit.

Vor allem wenn Strukturen mit einer Vielzahl von relativ einfach und gleichartig aufgebauten Elementen, zum Beispiel LCD-Punkt-Matrixanzeigen oder aber auch DRAMs, lediglich auf ihre Funktionsfähigkeit, aber dafür relativ schnell, zum Beispiel 10⁶ Elemente in 30 Sekunden, getestet werden sollen, ist das eingangs beschriebene bekannte Verfahren, wenn überhaupt, dann nur mit einem relativ hohen technischen Aufwand realisierbar.

Das erfindungsgemäße Korpuskularstrahltestverfahren besitzt zwar eine Gegenspannungsnachführung, um beispielsweise für verschiedene Probenspannungen jeweils die maximale Meßempfindlichkeit zu erhalten, kommt jedoch ohne den die Verarbeitungsgeschwindigkeit begrenzenden Regelkreis aus, da es sich hierbei nur um ein qualitatives Testverfahren - funktionsfähig oder fehlerhaft - handelt und ein linearer Zusammenhang zwischen dem Probenspannungshub und dem Gegenspannungshub nicht erforderlich ist.

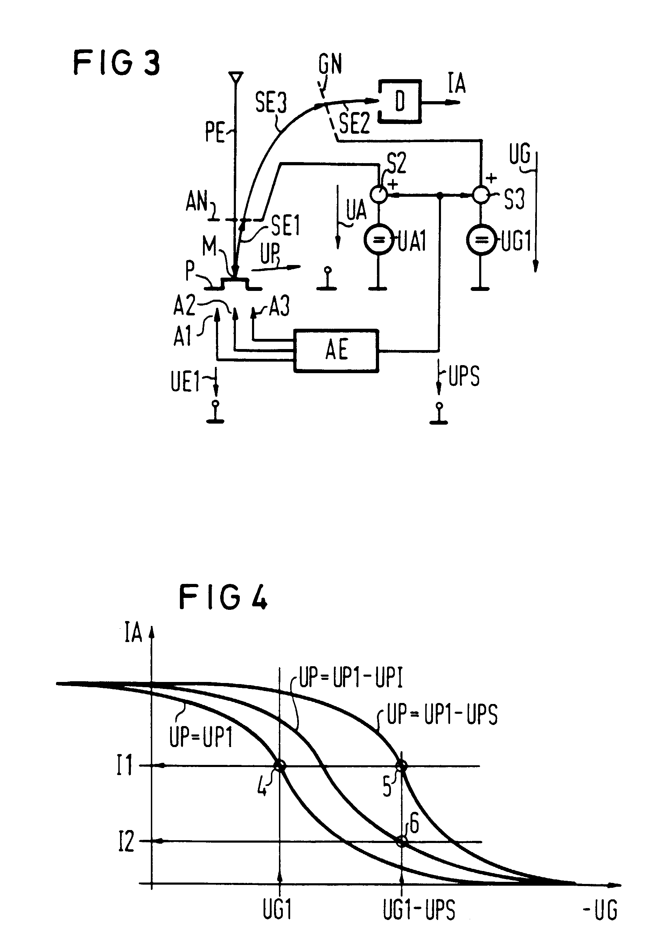

In Figur 3 ist ein Schaltbild einer Anordnung zur Durchführung eines erfindungsgemäßen Korpuskularstrahltestverfahrens dargestellt, bei dem, ähnlich wie bei Figur 1, ein Primärelektronenstrahl PE auf die Meßstelle M einer Probe P gerichtet ist und Sekundärelektronen SE1 erzeugt. Ein eventuell erforderliches weiteres Netz AN, beispielsweise ein Absaugnetz, kann relativ dicht oberhalb der Probe P vorgesehen sein und wird von einem Teil des Primärelektronenstrahls PE und von einem Teil der Sekundärelektronen SE1 getroffen. Ein durch das weitere Netz hindurchtretender Teil der Sekundärelektronen SE1 ist mit SE3 bezeichnet und erreicht das Gegenfeldnetz GN. Ein durch das Gegenfeldnetz GN hindurchtretender Teil der Sekundärelektronen SE3 ist mit SE2 bezeichnet und erzeugt, wie in Figur 1 bereits erläutert, im Detektor D einen Detektorstrom IA. Die Probe P besitzt beispielsweise Ansteueranschlüsse A1 ... A3, die durch eine Ansteuereinheit AE ansteuerbar sind. Beispielhaft ist eine Einstellspannung UE1 am Anschluß A1 gegenüber Bezugspotential eingetragen. Am Gegenfeldnetz liegt eine Gegenspannung UG, die an einer Summationsstelle S3 aus einer Grundgegenspannung UG1 und einem Soll-Probenspannungshub UPS, der in der Ansteuereinheit AE bildbar ist, erzeugt wird. In entsprechender Weise liegt gegebenenfalls am weiteren Netz AN eine Netzspannung UA, die an einer Summationsstelle S2 aus einer Grundnetzspannung UA1 und der Soll-Probenspannung UPS erzeugbar ist. Zwischen der Meßstelle M der Probe P und Bezugspotential liegt aufgrund von Einstellspannungen, beispielsweise der Einstellspannung UE1, die Probenspannung UP.

Figur 4 zeigt ein Diagramm mit Spektrometerkennlinien zur Anordnung gemäß Figur 3, bei dem über eine negative Gegenspannung -UG der Detektorstrom IA aufgetragen ist und eine erste Spektrometerkennlinie für eine Probenspannung UP = UP1, eine zweite Spektrometerkennlinie für eine Probenspannung UP = UP1 - UPS, und eine dritte Spektrometerkennlinie für eine Probenspannung UP = UP1 - UPI dargestellt sind, wobei UP1 eine Grundprobenspannung, die beispielsweise auch gleich 0 sein kann, UPI einen Ist-Probenspannungshub im Fehlerfall und UPS einen Soll-Probenspannungshub bezeichnet. Für den Fall, daß der Soll-Probenspannungshub UPS gleich 0 ist und somit die Probenspannung gleich der Probengrundspannung UP1 ist, entspricht die relative Gegenspannung UG der Grundgegenspannung UG1. Die Grundgegenspannung UG1 bildet zusammen mit der ersten Spektrometerkennlinie für die Probenspannung UP = UP1 in einem Arbeitspunkt 4 einen Soll-Detektorstrom I1. Besteht nun, im fehlerfreien Fall, die Probenspannung an der Meßstelle M aus der Grundprobenspannung UP1 und dem Soll-Probenspannungshub UPS, so wird die erste Spektrometerkennlinie für UP = UP1 lediglich wie bei Figur 2 in Richtung der UG-Achse verschoben, da der Grundgegenspannung UG1 an der Summationsstelle S3 ebenfalls genau der Soll-Probenspannungshub überlagert wird. Dies hat zur Folge, daß, sofern ein Probenspannungshub an einer Meßstelle M dem jeweiligen Soll-Probenspannungshub UPS für die Meßstelle M entspricht, der Detektorstrom IA dem Soll-Detektorstrom I1 entspricht. So führt in Figur 4 die Gegenspannung UG1 - UPS zusammen mit der zweiten Spektrometerkennlinie für UP = UP1 -UPS im Arbeitspunkt 5 ebenfalls zum Soll-Detektorstrom I1. Vorteilhafterweise wird der Arbeitspunkt 4 und damit auch der Arbeitspunkt 5 so gewählt, daß er jeweils den Punkt mit der größten Steilheit der jeweiligen Spektrometerkennlinie darstellt, da hierbei eine maximale Meßempfindlichkeit bzw. maximale Spannungshübe möglich sind. Wird bei einer fehlerhaften Probe P die Probenspannung UP beispielsweise nicht so stark negativ wie im fehlerfreien Fall, ist also ein Ist-Probenspannungshub UPI betragsmäßig kleiner als ein Soll-Probenspannungshub UPS, so wird die Energie der Sekundärelektronen SE1 nicht so stark erhöht wie im fehlerfreien Fall und die erste Spektrometerkennlinie der Grundprobenspannung UP1 wird nicht so stark in Richtung der negativen Gegenspannung -UG verschoben wie im fehlerfreien Fall. Da aber die negative Gegenspannung -UG auch für den Fall einer fehlerhaften Probe aus der Grundgegenspannung UG1 und dem Soll-Probenspannungshub UPS aus der Ansteuereinheit AE gebildet wird, hat dies zur Folge, daß durch das jeweils gleiche Gegenfeld des Gegennetzes GN die Sekundärelektronen SE3 zwar in beiden Fällen gleich stark abgebremst werden, die Energie der Sekundärelektronen SE1 im Fehlerfall hier jedoch geringer ist und damit bei fehlerhafter Probe ein geringerer Detektorstrom I2 entsteht als der Soll-Detektorstrom I1. So ergibt sich in Figur 4 beispielsweise für eine negative Gegenspannung -UG = UG1 - UPS und der dritten Spektrometerkennlinie für UP = UP1 - UPI in einem Arbeitspunkt 6 der Detektorstrom I2. Der Detektorstrom I2 einer fehlerhaften Probe kann je nach Art des Fehlers kleiner oder größer als der Soll-Detektorstrom I1 sein.

Für den Fall, daß sich mindestens ein weiteres Netz (AN) zwischen der Meßstelle (M) und dem Gegenfeldnetz (GN) befindet und teilweise vom Primärelektronenstrahl getroffen wird, muß die Spannung zwischen der Meßstelle (M) und dem jeweiligen weiteren Netz möglichst unabhängig von Änderungen der Probenspannung UP, also vom Probenspannungshub sein, um nicht eine Verfälschung des Detektorstromes (IA) zu erhalten. Wird erfindungsgemäß, wie in Figur 3 gezeigt, einer jeweiligen Grundnetzspannung (UA1) der Soll-Probenspannungshub (UPS) für die Meßstelle (M) überlagert, so kann im Falle einer fehlerfreien Probe eine Verfälschung des Detektorstromes vermieden und im Falle einer fehlerhaften Probe verringert werden.

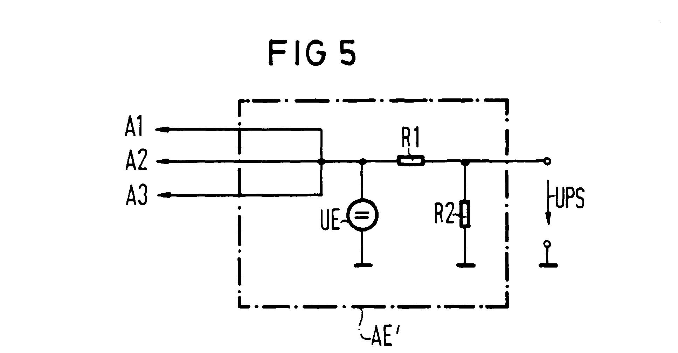

Die Ansteuereinheit AE kann im kompliziertesten Fall für jede Meßstelle M einen unterschiedlichen Einstellspannungsvektor für die Anschlüsse A1 ... A3 und jeweils unterschiedliche Soll-Spannungshübe UPS liefern. Eine Realisierungsmöglichkeit besteht in diesem Fall beispielsweise in Form eines Speichers oder eines Rechners mit nachgeschalteten D/A-Wandlern. Ferner kann in der Ansteuereinheit AE eine funktionsfähige Probe eingesetzt werden, die für jede Meßstelle zu einem jeweiligen Einstellspannungsvektor den entsprechenden Soll-Probenspannungshub UPS bildet. Zum Test von LCD-Punktmatrixanzeigen läßt sich jedoch eine sehr einfache Ansteuereinheit AE' angeben, da alle Elemente der LCD-Punktmatrixanzeige gleichzeitig und gleichartig aktiviert bzw. angesteuert werden können und der jeweilige Soll-Probenspannungshub UPS für jedes Element, also für jede Meßstelle gleich ist. Eine solche Ansteuereinheit AE' ist in Figur 5 gezeigt und besitzt eine Gleichspannungsquelle UE, die mit einem Spannungsteiler aus beispielsweise einem Widerstand R1 und einem Widerstand R2 verbunden ist. Die Gleichspannungsquelle UE liefert dabei für alle Ansteueranschlüsse A1 ... A3 der Probe P gleichzeitig die jeweilige Einstellspannung und durch den Spannungsteiler wird am Widerstand R2 ein für alle Meßstellen gleicher Soll-Probenspannungshub UPS erzeugt.

Als Korpuskularstrahl zur Erzeugung von Sekundärelektronen kann wie beschrieben ein Primärelektronenstrahl aber auch ein Ionenstrahl oder ein Laserstrahl verwendet werden.

Die als Elektroden dienenden Absaugnetze, Gegenfeldnetze und weiteren Netze sind dabei jeweils durch entsprechende Elektroden in Form von Blechen mit schlitzförmigen Öffnungen ersetzbar.

## Patentansprüche

1. Korpuskularstrahltestverfahren, bei dem ein Korpuskularstrahl (PE), insbesondere ein Elektronenstrahl, auf jeweils eine Meßstelle (M) einer Probe (P) gerichtet wird und infolgedessen Sekundärelektronen (SE1) gebildet werden, bei dem ein Teil (SE2) der Sekundärelektronen mindestens eine Gegenfeldelektrode (GN) durchquert, einen Detektor (D) erreicht und dort einen Detektorstrom (IA) bewirkt, bei dem der Detektorstrom (IA) von einer Probenspannung (UP) an der jeweiligen Meßstelle (M) und einer Gegenspannung (UG) der Gegenfeldelektrode abhängt und bei dem, bei Veränderung der Probenspannung (UP), die Gegenspannung nachgeführt wird**, dadurch gekennzeichnet,** daß durch eine Ansteuereinheit (AE) mindestens ein Anschluß (A1) der Probe (P) mit einer Einstellspannung (UE1) versorgt wird, daß der Meßstelle (M) aufgrund von mindestens einer Einstellspannung ein jeweiliger Ist-Probenspannungshub (UPI) erzeugt wird, daß die Gegenspannung dadurch nachgeführt wird, daß durch die Ansteuereinheit (AE) ein Soll-Probenspannungshub (UPS) erzeugt wird, der einer Grundgegenspannung (UG1) überlagert wird und zusammen mit der Grundgegenspannung die Gegenspannung (UG) an der Gegenfeldelektrode (GN) bildet, daß bei Veränderung von der mindestens einen Einstellspannung (UE1) der Detektorstrom (IA) konstant bleibt und einem Soll-Detektorstrom (I1) entspricht, sofern der Ist-Probenspannungshub (UPI) an der Meßstelle (M) den gleichen Wert besitzt wie der Soll-Probenspannungshub (UPS) für die jeweilige Meßstelle (M), und daß eine fehlerhafte Probe aufgrund einer Veränderung des Detektorstromes (IA) detektiert wird.

2. Korpuskularstrahltestverfahren nach Anspruch 1, **dadurch gekennzeichnet,** daß, sofern sich zwischen der Meßstelle (M) und der Gegenfeldelektrode (GN) mindestens eine weitere Elektrode (AN) befindet und vom Korpuskularstrahl (PE) teilweise getroffen wird, der Soll-Probenspannungshub (UPS) mindestens mit einer Grundelektrodenspannung (UA1) für die jeweilige weitere Elektrode (AN) zu einer jeweiligen Elektrodenspannung (UA) überlagert und die jeweilige Elektrodenspannung (UA) der jeweiligen weiteren Elektrode (AN) zugeführt wird.

3. Korpuskularstrahltestverfahren nach Anspruch 1 oder 2, **dadurch gekennzeichnet,** daß der Soll-Detektorstrom (I1) so gewählt wird, daß sich eine maximale Differenz zwischen Soll-Detektorstrom (I1) und Ist-Detektorstrom (I2) ergibt.

4. Korpuskularstrahltestverfahren nach einem der Ansprüche 1 bis 3, **dadurch gekennzeichnet,** daß die Ansteuereinheit (AE') nur aus einer Gleichspannungsquelle (UE) und einem Spannungsteiler (R1, R2) besteht, daß mehrere Ansteueranschlüsse (A1, A2, A3) der Probe (P) gleichzeitig mit der Gleichspannungsquelle verbunden sind und daß für alle Meßpunkte (M) der gleiche Soll-Probenspannungshub mit Hilfe des Spannungsteilers aus der Spannung der Gleichspannungsquelle gebildet wird.

5. Korpuskularstrahltestverfahren nach einem der Ansprüche 1 bis 4, **dadurch gekennzeichnet,** daß die Gegenfeldelektrode und/oder weitere Elektroden, sofern diese vorhanden sind, in Form von Netzen ausgebildet sind.

6. Korpuskularstrahltestverfahren nach einem der Ansprüche 1 bis 4, **dadurch gekennzeichnet,** daß die Gegenfeldelektrode und/oder weitere Elektroden, sofern diese vorhanden sind, in Form von Blechen mit schlitzförmigen Öffnungen ausgebildet sind.

## Claims

1. Method of corpuscular beam testing, wherein a corpuscular beam (PE), particularly an electron beam, is directed in each case onto a measurement point (M) of a specimen (P) and as a result secondary electrons (SE1) are formed, wherein a proportion (SE2) of the secondary electrons traverses at least one retarding field electrode (GN), reaches a detector (D) and there causes a detector current (IA), wherein the detector current (IA) is dependent upon a specimen voltage (UP) at the particular measurement point (M) and a reverse voltage (UG) of the retarding field electrode, and wherein the reverse voltage is reset when the specimen voltage (UP) alters, characterised in that at least one terminal (A1) of the specimen (P) is supplied with an adjusting voltage (UE1) by a control unit (AE), that on the basis of at least one adjusting voltage a respective actual specimen voltage variation (UPI) is generated at the measurement point (M), that the reverse voltage is reset thereby, that a desired specimen voltage variation (UPS) generated by the control unit (AE) is superimposed on a basic reverse voltage (UG1) and together with the basic reverse voltage forms the reverse voltage (UG) on the retarding field electrode (GN), that when at least one adjusting voltage (UE1) alters the detector current (IA) remains constant and corresponds to a desired detector current (I1) so long as the actual specimen voltage variation (UPI) at the measurement point (M) has the same value as the desired specimen voltage variation (UPS) for the particular measurement point (M), and that a defective specimen is detected on the basis of an alteration in the detector current (IA).

2. Method of corpuscular beam testing as claimed in Claim 1, characterised in that, in so far as at least one further electrode (AN) is located between the measurement point (M) and the retarding field electrode (GN) and is partially struck by the corpuscular beam (PE), the desired specimen voltage variation (UPS) is superimposed at least with a basic e!ectrode voltage (UA1) for the particular further electrode (AN) to a electrode voltage (UA) and the particular electrode voltage (UA) is supplied to the particular further electrode (AN).

3. Method of corpuscular beam testing as claimed in Claim 1 or 2, characterised in that the desired detector current (I1) is chosen so that a maximum difference is produced between the desired detector current (I1) and the actual detector current (I2).

4. Method of corpuscular beam testing as claimed in one of Claims 1 to 3, characterised in that the control unit (AE') consists only of a D.C. power source (UE) and a voltage divider (R1, R2), that a plurality of control terminals (A1, A2, A3) of the specimen (P) are simultaneously connected to the D.C. power source, and that for all measurement points (M) the same desired specimen voltage variation is formed from the voltage of the D.C. power source with the aid of the voltage divider.

5. Method of corpuscular beam testing as claimed in one of Claims 1 to 4, characterised in that the retarding field electrode and/or further electrodes, in so far as these are present, are constructed in the form of grids.

6. Method of corpuscular beam testing as claimed in one of Claims 1 to 4, characterised in that the retarding field electrode and/or further electrodes, in so far as these are present, are constructed in the form of plates with slot-shaped openings.

## Revendications

1. Procédé de contrôle par faisceau corpusculaire, suivant lequel un faisceau corpusculaire (PE), en particulier un faisceau d'électrons, est dirigé sur chaque lieu de mesure (M) d'un échantillon (P) et en conséquence des électrons secondaires (SE1) sont formés, suivant lequel une partie (SE2) des électrons secondaires traverse au moins une électrode à champ antagoniste (GN), atteint un détecteur (D) et y provoque un courant de détection (IA), suivant lequel le courant de détection (IA) est fonction d'une tension d'échantillon (UP) en le lieu particulier de mesure (M) et d'une contre-tension (UG) de l'électrode à champ antagoniste et suivant lequel la contre-tension est asservie lors d'une variation de la tension de l'échantillon (UP), caractérisé en ce qu'un circuit d'attaque (AE) alimente au moins une connexion (A1) de l'échantillon (P) en une tension de réglage (UE1), en ce qu'une excursion particulière de la tension réelle d'échantillon (UPI) est générée au lieu de mesure (M) en fonction d'au moins une tension de réglage, en ce que la contre-tension en est asservie, en ce que le circuit d'attaque (AE) génère une excursion de consigne de la tension d'échantillon (UPS) qui est superposée à une contre-tension de base (UG1) et forme avec la contre-tension de base la contre-tension (UG) sur l'électrode à champ antagoniste (GN), en ce que le courant de détection (IA) demeure constant et correspond à un courant de consigne de détection (I1) dans le cas de variations de l'au moins une tension de réglage (UE1) à condition que l'excursion réelle de la tension d'échantillon (UPI) au lieu de mesure (M) aie la même valeur que l'excursion de consigne de la tension d'échantillon (UPS) pour le lieu particulier de mesure (M) et en ce qu'un échantillon défectueux est détecté en raison d'une variation du courant de détection (IA).

2. Procédé de contrôle par faisceau corpusculaire selon la revendication 1, caractérisé en ce que, à condition qu'au moins une autre électrode (AN) se trouve entre le lieu de mesure (M) et l'électrode à champ antagoniste (GN) et qu'elle soit partiellement heurtée par le faisceau corpusculaire (PE), l'excursion de consigne de la tension d'échantillon (UPS) est superposée à une tension particulière d'électrode (UA) au moyen d'au moins une tension de base d'électrode (UA1) pour chaque autre électrode (AN) et la tension particulière d'électrode (UA) est envoyée à chaque autre électrode (AN).

3. Procédé de contrôle par faisceau corpusculaire selon la revendication 1 ou 2, caractérisé en ce que le courant de consigne de détection I1 est adopté de manière qu'il en résulte une différence maximale entre le courant de consigne de détection (I1) et le courant réel de détection (I2).

4. Procédé de contrôle par faisceau corpusculaire selon l'une des revendications 1 à 3, caractérisé en ce que le circuit d'attaque (AE') ne consiste qu'en une source de tension continue (UE) et en un diviseur de tension (R1, R2), en ce que plusieurs connexions d'attaque (A1, A2, A3) de l'échantillon (P) sont connectées simultanément à la source de tension continue et en ce que la même excursion de consigne de la tension d'échantillon est formée pour tous les points de mesure (M) à l'aide du diviseur de tension à partir de la tension de la source de tension continue.

5. Procédé de contrôle par faisceau corpusculaire selon l'une de revendications 1 à 4, caractérisé en ce que l'électrode à champ antagoniste et/ou d'autres électrodes, à condition que celles-ci soient présentes, sont réalisées sous forme de grilles.

6. Procédé de contrôle par faisceau corpusculaire selon l'une des revendications 1 à 4, caractérisé en ce que l'électrode à champ antagoniste et/ou d'autres électrodes, à condition que celles-ci soient présentes, sont réalisées sous la forme de tôles comportant des trous en forme de fentes.
